# EUROPÄISCHE PATENTANMELDUNG

(11) **EP 4 510 452 A1**
(43) Veröffentlichungstag der Anmeldung: **19.02.2025**
(21) Anmeldenummer: 23191945.7
(22) Anmeldetag: 17.08.2023
(51) Int. Cl.: H03K 17/082, H03K 17/74

(54) **ÜBERSPANNUNGSSCHUTZ FÜR EIN ELEKTRONISCHES SCHALTELEMENT**

(71) Anmelder: Siemens Aktiengesellschaft, 80333 München (DE)
(72) Erfinder: Hensler, Alexander, 91466 Gerhardshofen (DE)
(74) Vertreter: Siemens Patent Attorneys

(57) **Zusammenfassung**

Eine elektrische Schalteinrichtung (5 bis 7) weist zum Anschalten eines elektrischen Potenzials (U0, U1, U2) an eine Last (8) ein Schaltelement (9) mit einem ersten Leistungsanschluss (10), einem zweiten Leistungsanschluss (11) und einem ersten Steueranschluss (12) auf. Das Schaltelement (9) weist eine Durchbruchspannung auf, bis zu der es maximal betrieben werden kann. Der erste Steueranschluss (12) ist mit einer ersten Treiberschaltung (13) verbunden, über welche dem ersten Steueranschluss (12) ein erstes Steuersignal (S1) zuführbar ist, so dass das Schaltelement (9) je nach Wert des ersten Steuersignals (S1) für einen Stromfluss von dem ersten zum zweiten Leistungsanschluss (10, 11) durchgeschaltet oder gesperrt ist. Der erste Steueranschluss (12) ist über eine erste Diodenschaltung (16) mit dem ersten Leistungsanschluss (10) verbunden. Die erste Diodenschaltung (16) umfasst eine Reihenschaltung einer ersten und einer zweiten Diode (17, 18). Von dem ersten Leistungsanschluss (10) zum ersten Steueranschluss (12) gesehen ist die erste Diode (17) in Durchlassrichtung gepolt, die zweite Diode (18) in Sperrrichtung. Die zweite Diode (18) ist als Zenerdiode ausgebildet ist und weist eine Durchbruchspannung zwischen einer Betriebsspannung (U) der elektrischen Schalteinrichtung (5 bis 7) und der Durchbruchspannung des Schaltelements (9) auf. Die erste Diode (17) weist eine Durchbruchspannung oberhalb der Durchbruchspannung des Schaltelements (9) auf.

## Beschreibung

Die vorliegende Erfindung geht aus von einer elektrischen Schalteinrichtung zum Anschalten eines elektrischen Potenzials an eine Last,
- wobei die Schalteinrichtung ein Schaltelement mit einem ersten Leistungsanschluss, einem zweiten Leistungsanschluss und einem ersten Steueranschluss aufweist,
- wobei das Schaltelement eine Durchbruchspannung aufweist, bis zu der es maximal betrieben werden kann,
- wobei der erste Steueranschluss mit einer ersten Treiberschaltung verbunden ist, über welche dem ersten Steueranschluss ein erstes Steuersignal zuführbar ist, so dass das Schaltelement je nach Wert des ersten Steuersignals für einen Stromfluss von dem ersten zum zweiten Leistungsanschluss durchgeschaltet oder gesperrt ist,
- wobei der erste Steueranschluss über eine erste Diodenschaltung mit dem ersten Leistungsanschluss verbunden ist,
- wobei die erste Diodenschaltung eine Reihenschaltung einer ersten und einer zweiten Diode umfasst,
- wobei von dem ersten Leistungsanschluss zum ersten Steueranschluss gesehen die erste Diode in Durchlassrichtung gepolt ist und die zweite Diode in Sperrrichtung gepolt ist,
- wobei die zweite Diode als Zenerdiode ausgebildet ist und eine Durchbruchspannung zwischen einer Betriebsspannung der elektrischen Schalteinrichtung und der Durchbruchspannung des Schaltelements aufweist.

Eine derartige Schalteinrichtung ist allgemein bekannt. Sie wird insbesondere in Umrichtern verwendet.

Beim Ausschalten des Schaltelements - beispielsweise eines IGBTs - entsteht aufgrund von parasitären Induktivitäten und Streuinduktivitäten kurzfristig eine Überspannung. Die Höhe dieser Überspannung kann insbesondere im Kurzschlussfall die Durchbruchspannung des Schaltelements erreichen und sogar übersteigen, wenn sie nicht begrenzt würde. In diesem Fall könnte die Überspannung das Schaltelement zerstören.

Zur Begrenzung einer derartigen Überspannung dient die erste Diodenschaltung.

Die erste Diode der Diodenschaltung hat die Funktion, im durchgeschalteten Zustand des Schaltelements (wenn also die beiden Leistungsanschlüsse niederohmig miteinander verbunden sind) einen Stromfluss von der ersten Treiberschaltung zum ersten Leistungsanschluss zu verhindern. Die Sperrspannung bzw. Durchbruchspannung der ersten Diode muss daher lediglich größer als die maximal mögliche Ausgangsspannung der ersten Treiberschaltung sein. Die maximal mögliche Ausgangsspannung der ersten Treiberschaltung liegt bei Leistungsschaltern in der Praxis meist im Bereich zwischen 25 V und 50 V, meist sogar im Bereich zwischen 30 V und 40 V. Entsprechend ist die erste Diode im Stand der Technik ausgelegt.

Der eigentliche Überspannungsschutz wird durch die zweite Diode realisiert, die als Zenerdiode ausgebildet ist. Übersteigt die Überspannung die Zenerspannung der Zenerdiode, wird die Zenerdiode leitend. Dadurch fließt Strom von dem ersten Leistungsanschluss zum ersten Steueranschluss. Dieser Strom führt dazu, dass der Ausschaltvorgang des Schaltelements verlangsamt wird. Dadurch verringert sich die Geschwindigkeit, mit welcher der geschaltete Strom abfällt. Aufgrund der verringerten Geschwindigkeit verringert sich die Überspannung. Die Zenerspannung der Zenerdiode wird meist so gewählt, dass sie in etwa in der Mitte zwischen der Betriebsspannung der elektrischen Schalteinrichtung und der Durchbruchspannung des Schaltelements liegt.

Ein derartiger Schutz vor Überspannungen ist bei einem Zweilevel-Umrichter ohne weiteres realisierbar. Bei einem Dreilevel-Umrichter ist ein derartiger Schutz für die Schaltelemente, welche das hohe und das niedrige Gleichspannungspotenzial des Dreilevel-Umrichters mit dem Wechselspannungsanschluss des Dreilevel-Umrichters verbinden, ebenfalls ohne weiteres realisierbar. Bei einem Dreilevel-Umrichter kann jedoch der Fall auftreten, dass ein derartiger Schutz für diejenigen Schaltelemente, welche das mittlere Gleichspannungspotenzial des Dreilevel-Umrichters mit dem Wechselspannungsanschluss verbinden, nicht oder nur mit erheblichen Schwierigkeiten realisierbar ist. Insbesondere kann es zu diesem Zweck im Stand der Technik erforderlich sein, einen Anschluss eines derartigen Schaltelements zu kontaktieren, der nicht ohne weiteres zugänglich ist.

Die Aufgabe der vorliegenden Erfindung besteht darin, eine Schalteinrichtung der eingangs genannten Art derart weiterzuentwickeln, dass sie einen Überspannungsschutz für das Schaltelement unabhängig davon realisieren kann, an welcher Stelle eines größeren Schaltkreises die Schalteinrichtung eingesetzt wird. Insbesondere soll der Überspannungsschutz auch dann realisiert werden können, wenn die Schalteinrichtung für das Verbinden des mittleren Gleichspannungspotentials eines Dreilevel-Umrichters mit dem Wechselspannungsanschluss des Dreilevel-Umrichters verwendet wird.

Die Aufgabe wird durch eine Schalteinrichtung mit den Merkmalen des Anspruchs 1 gelöst. Vorteilhafte Ausgestaltungen der Schalteinrichtung sind Gegenstand der abhängigen Ansprüche 2 bis 15.

Erfindungsgemäß wird eine Schalteinrichtung der eingangs genannten Art dadurch ausgestaltet, dass die erste Diode eine Durchbruchspannung oberhalb der Durchbruchspannung des Schaltelements aufweist.

In vielen Fällen ist das Schaltelement als spannungsgesteuertes Schaltelement ausgebildet ist, beispielsweise auf IGBT-Basis oder auf FET-Basis. Diese Ausgestaltung ist weit verbreitet, arbeitet zuverlässig und weist geringe Schaltverluste auf.

Vorzugsweise ist von dem ersten Leistungsanschluss zum ersten Steueranschluss gesehen die zweite Diode vor der ersten Diode angeordnet. Diese Ausgestaltung weist den Vorteil auf, dass für die Realisierung des Überspannungsschutzes nur (exakt) zwei Dioden benötigt werden und einerseits dennoch ein Anschlusspunkt zugänglich ist, der vom ersten Leistungsanschluss zum ersten Steueranschluss gesehen hinter der zweiten Diode liegt, jedoch andererseits zwischen dem Anschlusspunkt und dem ersten Steueranschluss noch eine weitere Diode liegt, nämlich die genannte erste Diode. Diese Ausgestaltung weist Vorteile für bestimmte Funktionen der Ansteuerung des ersten Steueranschlusses auf.

Alternativ ist es möglich, dass von dem ersten Leistungsanschluss zum ersten Steueranschluss gesehen die erste Diode zwar vor der zweiten Diode angeordnet ist, die erste Diodenschaltung jedoch zusätzlich eine dritte Diode umfasst, die von dem ersten Leistungsanschluss zum ersten Steueranschluss gesehen nach der zweiten Diode angeordnet ist und von dem ersten Leistungsanschluss zum ersten Steueranschluss gesehen in Durchlassrichtung gepolt ist. In diesem Fall wird die Lage des Anschlusspunktes zwischen der zweiten und der dritten Diode realisiert.

Es ist weiterhin möglich, dass die erste Diode eine Durchbruchspannung oberhalb der Durchbruchspannung des Schaltelements aufweist. In diesem Fall kann die Durchbruchspannung der dritten Diode nahezu beliebig gewählt werden. Die erste und die dritte Diode sind jedoch, soweit es den Überspannungsschutz betrifft, gleichwertig. In Abwandlung des Grundprinzips der vorliegenden Erfindung ist es daher möglich, dass zwar die erste Diode eine Durchbruchspannung unterhalb der Durchbruchspannung des Schaltelements aufweist, die Summe der Durchbruchspannungen der ersten und der dritten Diode zusammen jedoch oberhalb der Durchbruchspannung des Schaltelements liegt. In diesem Fall erfolgt sozusagen eine Aufteilung der erforderlichen resultierenden Durchbruchspannung auf die erste und die dritte Diode.

In manchen Fällen kann es, soweit es die Schalteinrichtung betrifft, zulässig sein, dass ein Stromfluss von dem zweiten zum ersten Leistungsanschluss unabhängig davon möglich ist, ob das Schaltelement aufgrund des ersten Steuersignals für den Stromfluss von dem ersten zum zweiten Leistungsanschluss durchgeschaltet oder gesperrt ist. In diesem Fall wird in der Regel der Stromfluss von dem zweiten zum ersten Leistungsanschluss durch eine weitere Schalteinrichtung geregelt, die in der Regel ebenfalls erfindungsgemäß ausgebildet ist. Ein derartiger Fall liegt beispielsweise bei einem Zweilevel-Umrichter vor. In diesem Fall kann eine jeweilige Schalteinrichtung das hohe und das niedrige Gleichspannungspotenzial mit dem Wechselspannungsanschluss des Zweilevel-Umrichters verbinden und jede der Schalteinrichtungen kann erfindungsgemäß ausgebildet sein. Bei einem Dreilevel-Umrichter gilt dies für diejenigen Schaltelemente, welche das hohe und das niedrige Gleichspannungspotenzial mit dem Wechselspannungsanschluss des Dreilevel-Umrichters verbinden.

Oftmals wird die erfindungsgemäße Schalteinrichtung jedoch zum Verbinden des mittleren Gleichspannungspotenzials eines Dreilevel-Umrichters mit dem Wechselspannungsanschluss des Dreilevel-Umrichters verwendet. In diesem Fall weist das Schaltelement einen zweiten Steueranschluss auf, der mit einer zweiten Treiberschaltung verbunden ist, über welche dem zweiten Steueranschluss ein zweites Steuersignal zuführbar ist, so dass das Schaltelement je nach Wert des zweiten Steuersignals für einen Stromfluss von dem zweiten zum ersten Leistungsanschluss durchgeschaltet oder gesperrt ist. Somit kann der Stromfluss in beide Richtungen nach Bedarf durchgeschaltet oder gesperrt werden.

Meist werden die beiden Steueranschlüsse prinzipiell gleichartig angesteuert. In diesem Fall können unter Umständen die erste und die zweite Treiberschaltung zu einer gemeinsamen Treiberschaltung zusammengefasst sein.

Um in dem Fall, dass mittels des zweiten Steuersignals der Stromfluss von dem zweiten zum ersten Leistungsanschluss durchgeschaltet oder gesperrt werden kann, einen vollständigen Überspannungsschutz gewährleisten zu können, ist die Schalteinrichtung vorzugsweise derart ausgestaltet,
- dass der zweite Steueranschluss über eine zweite Diodenschaltung mit dem zweiten Leistungsanschluss verbunden ist,
- dass die zweite Diodenschaltung eine Reihenschaltung einer vierten und einer fünften Diode umfasst,
- dass von dem zweiten Leistungsanschluss zum zweiten Steueranschluss gesehen die vierte Diode in Durchlassrichtung gepolt ist und die fünfte Diode in Sperrrichtung gepolt ist,
- dass die vierte Diode eine Durchbruchspannung oberhalb der Durchbruchspannung des Schaltelements aufweist und
- dass die fünfte Diode als Zenerdiode ausgebildet ist und eine Durchbruchspannung zwischen der Betriebsspannung und der Durchbruchspannung des Schaltelements aufweist.

Bei der zweiten Diodenschaltung können die vorstehend erläuterten Ausgestaltungen der ersten Diodenschaltung in analoger Weise realisiert sein. Die vierte Diode kann von dem zweiten Leistungsanschluss zum zweiten Steueranschluss gesehen also vor oder nach der fünften Diode angeordnet sein. Im Falle der Anordnung vor der fünften Diode ist vorzugsweise zusätzlich eine sechste Diode vorhanden, die von dem zweiten Leistungsanschluss zum zweiten Steueranschluss gesehen nach der fünften Diode angeordnet ist und von dem zweiten Leistungsanschluss zum zweiten Steueranschluss gesehen in Durchlassrichtung gepolt ist. Gegebenenfalls kann - analog zur ersten und dritten Diode - auch wieder die Aufteilung der insgesamt erforderlichen Durchbruchspannung auf die vierte und die sechste Diode vorgenommen werden.

In vielen Fällen weist das Schaltelement ein erstes und ein zweites Transistorelement auf, wobei das erste und das zweite Transistorelement in Reihe geschaltet sind. Der erste Steueranschluss ist in diesem Fall Bestandteil des ersten Transistorelements, der zweite Steueranschluss Bestandteil des zweiten Transistorelements. Den beiden Transistorelementen ist jeweils eine Freilaufdiode parallelgeschaltet. Die dem ersten Transistorelement parallelgeschaltete erste Freilaufdiode ist von dem ersten zum zweiten Leistungsanschluss gesehen in Sperrrichtung gepolt, die dem zweiten Transistorelement parallelgeschaltete zweite Freilaufdiode in Durchlassrichtung.

Vorzugsweise ist im Falle der Serienschaltung der beiden Transistorelemente von dem ersten zum zweiten Leistungsanschluss gesehen das zweite Transistorelement vor dem ersten Transistorelement angeordnet. Diese Ausgestaltung ist allgemein üblich.

Alternativ zu einer Serienschaltung der beiden Transistorelemente ist es möglich, dass das Schaltelement zwar zwei Transistorelemente aufweist, die beiden Transistorelemente jedoch parallelgeschaltet sind. Auch in diesem Fall ist der erste Steueranschluss Bestandteil des ersten Transistorelements und ist der zweite Steueranschluss Bestandteil des zweiten Transistorelements. Parallelgeschaltete oder in Serie geschaltete Dioden ähnlich zu den Freilaufdioden der Serienschaltung zweier Transistorelemente sind jedoch nicht vorhanden. Ein derartiges Schaltelement wird beispielsweise von der Firma Fuji vermarktet.

Alternativ zu einer Verwendung zweier Transistorelemente ist es auch möglich, dass das Schaltelement als intrinsisch bidirektional schaltbares Schaltelement ausgebildet ist. Ein derartiges Schaltelement ist beispielsweise ein so genannter bidirectional switch, insbesondere auf GaN-Basis. Ein derartiges Switch wird beispielsweise von der Firma Panasonic vermarktet.

Wie bereits erwähnt, ist vorzugsweise der erste Leistungsanschluss mit einem mittleren von drei Gleichspannungspotentialen eines Dreilevel-Umrichters verbunden und ist der zweite Leistungsanschluss mit einem Wechselspannungsanschluss des Dreilevel-Umrichters verbunden. Bei dieser Ausgestaltung zeigt die vorliegende Erfindung ihre vollen Vorteile.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: eine elektrische Schaltung,
- FIG 2: eine Umrichtereinheit,
- FIG 3: eine Modifikation der Umrichtereinheit von FIG 2,
- FIG 4: eine Umrichtereinheit,
- FIG 5: eine Modifikation der Umrichtereinheit von FIG 4,
- FIG 6: ein Schaltelement,
- FIG 7: ein weiteres Schaltelement und
- FIG 8: ein weiteres Schaltelement.

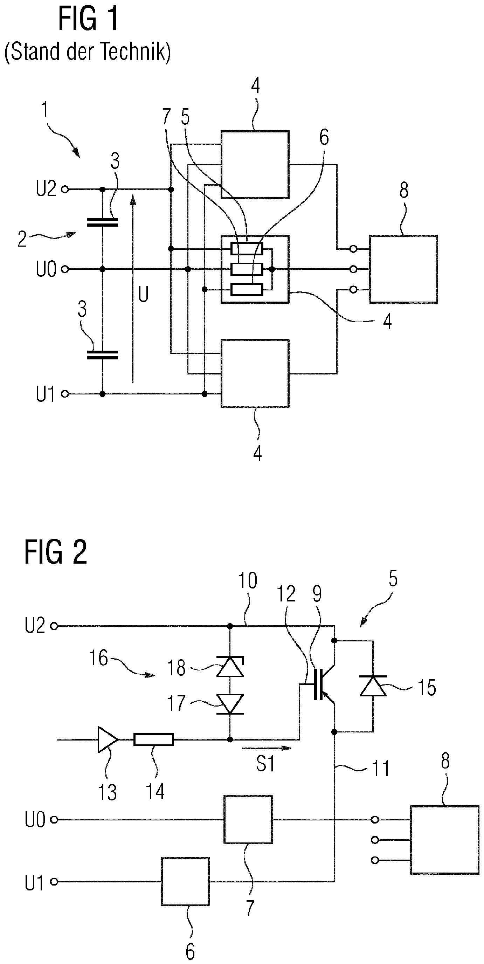

Gemäß FIG 1 weist ein Gleichspannungskreis 1 ein niedriges Potenzial U1 und ein hohes Potenzial U2 auf. Die beiden Potenziale U1, U2 sind durch eine Kondensatoreinrichtung 2 miteinander verbunden. Vorliegend weist die Kondensatoreinrichtung zwei in Serie geschaltete Kondensatoreinheiten 3 auf. Dadurch ist der Gleichspannungskreis 1 in der Lage, zusätzlich zu dem niedrigen Potenzial U1 und dem hohen Potenzial U2 auch ein mittleres Potenzial U0 zur Verfügung zu stellen.

Die drei Potenziale U0, U1, U2 sind mit mehreren (in der Regel drei) Umrichtereinheiten 4 verbunden. Die Umrichtereinheiten 4 - dargestellt ist dies in FIG 1 nur für eine der Umrichtereinheiten 4 - weisen jeweils eine erste, eine zweite und eine dritte elektrische Schalteinrichtung 5 bis 7 auf. Über die jeweilige Schalteinrichtung 5 bis 7 (genauer: über einen jeweiligen Wechselspannungsanschluss der jeweiligen Umrichtereinheit 4) kann jeweils eines der drei Potenziale U0, U1, U2 einer Last 8 zugeführt werden.

Bei der Schaltung von FIG 1 sind die Umrichtereinheiten 4 jeweils als Dreilevelumrichter ausgebildet. Die jeweilige dritte Schalteinrichtung 7 könnte jedoch auch entfallen. In diesem Fall sind die Umrichtereinheiten 4 jeweils als Zweilevelumrichter ausgebildet. In diesem Fall könnte weiterhin die Kondensatoreinrichtung 2 als einheitliche Kondensatoreinrichtung ausgebildet sein. Die Aufteilung in zwei in Serie geschaltete Kondensatoreinheiten 3 könnte also entfallen, so dass das mittlere Potenzial U0 gar nicht zur Verfügung gestellt wird.

Weiterhin wird vorliegend angenommen, dass der Energiefluss vom Gleichspannungskreis 1 zur Last 8 erfolgt. Prinzipiell ist aber auch der umgekehrte Energiefluss möglich.

Nachfolgend wird in Verbindung mit FIG 2 anhand einer der Umrichtereinheiten 4 der Aufbau der ersten elektrischen Schalteinrichtung 5 näher erläutert. Für die zweite elektrische Schalteinrichtung 6 gelten analoge Ausführungen. Der Aufbau der dritten elektrischen Schalteinrichtung 7 wird später separat erläutert.

Gemäß FIG 2 weist die erste Schalteinrichtung 5 ein Schaltelement 9 mit einem ersten Leistungsanschluss 10 und einem zweiten Leistungsanschluss 11 auf. Üblicherweise ist das Schaltelement 9 als spannungsgesteuertes Schaltelement ausgebildet, beispielsweise als IGBT oder als FET.

Der erste Leistungsanschluss 10 ist mit dem Potenzial U2 verbunden. Der zweite Leistungsanschluss 11 ist mit der Last 8 verbunden. Das Schaltelement 9 weist weiterhin einen ersten Steueranschluss 12 und eine erste Treiberschaltung 13 auf. Die erste Treiberschaltung 13 ist mit dem ersten Steueranschluss 12 (meist über einen Widerstand 14) verbunden, so dass dem ersten Steueranschluss 12 von der ersten Treiberschaltung 13 ein erstes Steuersignal S1 zugeführt wird. Das erste Steuersignal S1 ist in der Regel binär, weist also entweder einen hohen oder einen niedrigen Wert auf. Bei einem der Werte ist das Schaltelement 9 für einen Stromfluss von dem ersten zum zweiten Leistungsanschluss 10, 11 durchgeschaltet. Bei dem anderen der Werte ist das Schaltelement 9 für einen Stromfluss von dem ersten zum zweiten Leistungsanschluss 10, 11 gesperrt.

Die Richtung des Stromflusses ist vorliegend relevant. Denn ersichtlich ist dem Schaltelement 9 eine Freilaufdiode 15 parallelgeschaltet. Die Freilaufdiode 15 kann ein intrinsischer Bestandteil des Schaltelements 9 sein. Alternativ kann es sich um eine eigenständige Diode (also ein diskretes Bauteil) handeln. Über die Freilaufdiode 15 ist ein Stromfluss in der umgekehrten Richtung (also vom zweiten zum ersten Leistungsanschluss 11, 10) unabhängig davon möglich, ob das Schaltelement 9 aufgrund des ersten Steuersignals S1 für den Stromfluss von dem ersten zum zweiten Leistungsanschluss 10, 11 durchgeschaltet oder gesperrt ist. Ob tatsächlich ein Stromfluss vom zweiten zum ersten Leistungsanschluss 11, 10 erfolgt oder nicht, wird im Regelfall durch eine der Schalteinrichtungen 5 bis 7 einer der anderen Umrichtereinheiten 4 gesteuert.

Der erste Steueranschluss 12 ist über eine erste Diodenschaltung 16 mit dem ersten Leistungsanschluss 10 verbunden. Die erste Diodenschaltung 16 umfasst eine Reihenschaltung einer ersten und einer zweiten Diode 17, 18. Von dem ersten Leistungsanschluss 10 zum ersten Steueranschluss 12 gesehen ist die erste Diode 17 in Durchlassrichtung gepolt. Die zweite Diode 18 ist in Sperrrichtung gepolt.

Die erste Diode 17 ist als "normale" Diode ausgebildet. Die zweite Diode 18 ist hingegen als Zenerdiode ausgebildet.

Entscheidend für die vorliegende Erfindung ist die Auslegung der ersten und der zweiten Diode 17, 18, konkret die Festlegung der Durchbruchspannung der ersten Diode 17 und die Festlegung der Durchbruchspannung der zweiten Diode 18.

Ausgangspunkt ist die übrige Auslegung der elektrischen Schalteinrichtung 5. Zum einen weist das Schaltelement 9 eine Durchbruchspannung auf, bis zu der es maximal betrieben werden kann. Weiterhin wird die elektrische Schalteinrichtung 5 mit einer Betriebsspannung U betrieben. Die Betriebsspannung U ist die Differenz zwischen dem hohen Potenzial U2 und dem niedrigen Potenzial U1. Die zweite Diode 18 weist eine Durchbruchspannung zwischen der Betriebsspannung U und der Durchbruchspannung des Schaltelements 9 auf. Die erste Diode 17 hingegen weist eine Durchbruchspannung oberhalb der Durchbruchspannung des Schaltelements 9 auf.

Wenn beispielsweise die Betriebsspannung U bei ca. 400 V liegt, muss zunächst die Durchbruchspannung des Schaltelements 9 in hinreichendem Umfang oberhalb von 400 V liegen. Anderenfalls wäre ein ordnungsgemäßes Funktionieren des Schaltelements 9 nicht möglich. Insbesondere könnte anderenfalls der Stromfluss von dem ersten zum zweiten Leistungsanschluss 10, 11 von dem Schaltelement 9 nicht gesperrt werden. Typischerweise liegt bei einer Betriebsspannung U von ca. 400 V die Durchbruchspannung des Schaltelements 9 bei ca. 650 V. Die Durchbruchspannung der zweiten Diode 18 (also die Zenerspannung) liegt üblicherweise in etwa in der Mitte zwischen der Betriebsspannung U und der Durchbruchspannung des Schaltelements 9, vorliegend also bei etwa 525 V. Die Durchbruchspannung der ersten Diode 17 muss vorliegend hingegen oberhalb von 650 V liegen, beispielsweise bei 700 V bis 1000 V.

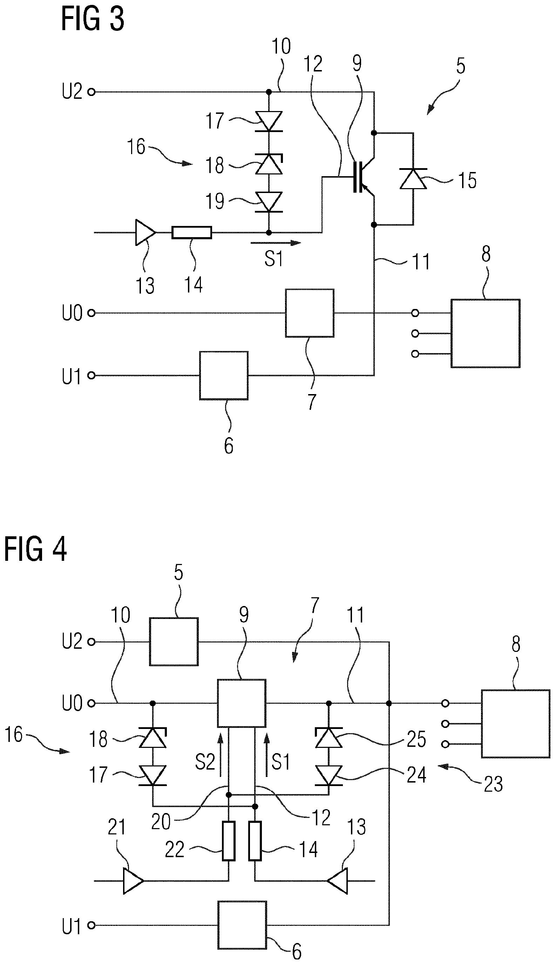

Bei der vorstehend in Verbindung mit FIG 2 erläuterten Ausgestaltung der Schalteinrichtung 5 ist von dem ersten Leistungsanschluss 10 zum ersten Steueranschluss 12 gesehen die zweite Diode 18 vor der ersten Diode 17 angeordnet. Es ist jedoch gemäß FIG 3 alternativ ebenso möglich, die umgekehrte Reihenfolge vorzusehen. In diesem Fall ist von dem ersten Leistungsanschluss 10 zum ersten Steueranschluss 12 gesehen die erste Diode 17 vor der zweiten Diode 18 angeordnet.

Vorzugsweise umfasst die erste Diodenschaltung 16 in diesem Fall entsprechend der Darstellung in FIG 3 zusätzlich eine dritte Diode 19. Die dritte Diode 19 ist von dem ersten Leistungsanschluss 10 zum ersten Steueranschluss 12 gesehen nach der zweiten Diode 18 angeordnet und von dem ersten Leistungsanschluss 10 zum ersten Steueranschluss 12 gesehen in Durchlassrichtung gepolt.

Auch die dritte Diode 19 weist eine Durchbruchspannung auf. Prinzipiell können die Durchbruchspannungen der ersten und der dritten Diode 17, 19 addiert werden. Bei der Ausgestaltung gemäß FIG 3 ist es daher möglich, dass die erste Diode 17 eine Durchbruchspannung unterhalb der Durchbruchspannung des Schaltelements 9 aufweist. Denn es ist ausreichend, dass die Summe der Durchbruchspannungen der ersten und der dritten Diode 17, 19 zusammen oberhalb der Durchbruchspannung des Schaltelements 9 liegt.

FIG 4 zeigt eine weitere Umrichtereinheit 4. In Verbindung mit FIG 4 wird der Aufbau der dritten elektrischen Schalteinrichtung 7 näher erläutert. Soweit es die erste und die zweite Schalteinrichtung 5, 6 betrifft, können diese so ausgebildet sein, wie dies vorstehend in Verbindung mit den FIG 2 und 3 erläutert wurde. Sie können aber auch andersartig ausgebildet sein. Soweit die dritte elektrische Schalteinrichtung 7 die gleichen Komponenten aufweist wie die erste elektrische Schalteinrichtung 5, werden nachstehend auch die gleichen Bezugszeichen verwendet.

Gemäß FIG 4 weist die dritte Schalteinrichtung 7 ein Schaltelement 9 mit einem ersten Leistungsanschluss 10 und einem zweiten Leistungsanschluss 11 auf. Der erste Leistungsanschluss 10 ist bei der dritten Schalteinrichtung 7 mit dem mittleren Potenzial U0 verbunden. Der zweite Leistungsanschluss 11 ist mit der Last 8 verbunden. Das Schaltelement 9 weist weiterhin einen ersten Steueranschluss 12 und eine erste Treiberschaltung 13 auf. Die erste Treiberschaltung 13 ist mit dem ersten Steueranschluss 12 (meist über einen Widerstand 14) verbunden, so dass dem ersten Steueranschluss 12 von der ersten Treiberschaltung 13 ein erstes Steuersignal S1 zugeführt wird. Das erste Steuersignal S1 ist in der Regel binär, weist also entweder einen hohen oder einen niedrigen Wert auf. Bei einem der Werte ist das Schaltelement 9 für einen Stromfluss von dem ersten zum zweiten Leistungsanschluss 10, 11 durchgeschaltet. Bei dem anderen der Werte ist das Schaltelement 9 für einen Stromfluss von dem ersten zum zweiten Leistungsanschluss 10, 11 gesperrt.

Die Richtung des Stromflusses ist vorliegend weiterhin relevant. Denn zusätzlich zu dem ersten Steueranschluss 12 weist das Schaltelement 9 einen zweiten Steueranschluss 20 und eine zweite Treiberschaltung 21 auf. Die zweite Treiberschaltung 21 ist mit dem zweiten Steueranschluss 20 (meist über einen Widerstand 22) verbunden, so dass dem zweiten Steueranschluss 20 von der zweiten Treiberschaltung 21 ein zweites Steuersignal S2 zugeführt wird. Das zweite Steuersignal S2 ist in der Regel ebenfalls binär, weist also entweder einen hohen oder einen niedrigen Wert auf. Bei einem der Werte ist das Schaltelement 9 für einen Stromfluss von dem zweiten zum ersten Leistungsanschluss 11, 10 durchgeschaltet. Bei dem anderen der Werte ist das Schaltelement 9 für einen Stromfluss von dem zweiten zum ersten Leistungsanschluss 11, 10 gesperrt.

Mittels des Schaltelements 9 der dritten Schalteinrichtung 7 kann also für die beiden Richtungen des Stromflusses unabhängig voneinander eingestellt werden, ob das Schaltelement 9 für den jeweiligen Stromfluss durchgeschaltet oder gesperrt ist. Mögliche Ausgestaltungen des Schaltelements 9 der dritten Schalteinrichtung 7 werden später noch näher erläutert.

Der erste Steueranschluss 12 ist über eine erste Diodenschaltung 16 mit dem ersten Leistungsanschluss 10 verbunden. Die erste Diodenschaltung 16 umfasst eine Reihenschaltung einer ersten und einer zweiten Diode 17, 18. Von dem ersten Leistungsanschluss 10 zum ersten Steueranschluss 12 gesehen ist die erste Diode 17 in Durchlassrichtung gepolt. Die zweite Diode 18 ist in Sperrrichtung gepolt. Die erste Diode 17 ist als "normale" Diode ausgebildet. Die zweite Diode 18 ist hingegen als Zenerdiode ausgebildet.

In analoger Weise ist der zweite Steueranschluss 20 über eine zweite Diodenschaltung 23 mit dem zweiten Leistungsanschluss 11 verbunden. Die zweite Diodenschaltung 23 umfasst eine Reihenschaltung einer vierten und einer fünften Diode 24, 25. Von dem zweiten Leistungsanschluss 11 zum zweiten Steueranschluss 20 gesehen ist die vierte Diode 24 in Durchlassrichtung gepolt. Die fünfte Diode 25 ist in Sperrrichtung gepolt. Die vierte Diode 24 ist als "normale" Diode ausgebildet. Die fünfte Diode 25 ist hingegen als Zenerdiode ausgebildet.

Entscheidend für die vorliegende Erfindung ist die Auslegung der ersten und der zweiten Diode 17, 18 sowie der vierten und der fünften Diode 24, 25, konkret die Festlegung der Durchbruchspannungen der genannten Dioden 17, 18, 24 und 25.

Für die erste und die zweite Diode 17, 18 gelten weiterhin die obigen, in Verbindung mit FIG 2 getroffenen Ausführungen. Die zweite Diode 18 weist also eine Durchbruchspannung zwischen der Betriebsspannung U und der Durchbruchspannung des Schaltelements 9 auf, die erste Diode 17 eine Durchbruchspannung oberhalb der Durchbruchspannung des Schaltelements 9.

Für die vierte und die fünfte Diode 24, 25 gelten analoge Ausführungen. Die fünfte Diode 25 weist also eine Durchbruchspannung zwischen der Betriebsspannung U und der Durchbruchspannung des Schaltelements 9 auf, die vierte Diode 24 eine Durchbruchspannung oberhalb der Durchbruchspannung des Schaltelements 9.

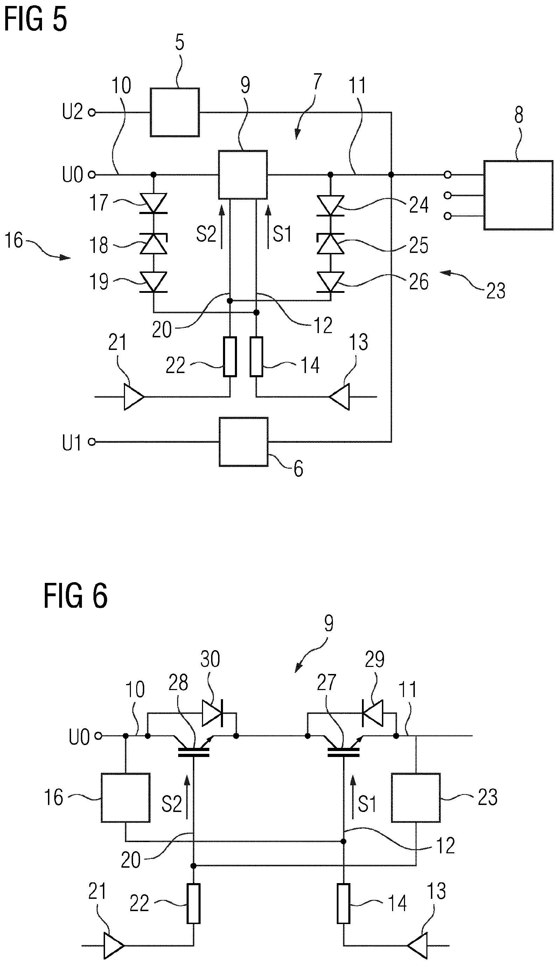

Bei der vorstehend in Verbindung mit FIG 4 erläuterten Ausgestaltung der dritten Schalteinrichtung 7 ist von dem ersten Leistungsanschluss 10 zum ersten Steueranschluss 12 gesehen die zweite Diode 18 vor der ersten Diode 17 angeordnet. Ebenso ist von dem zweiten Leistungsanschluss 11 zum zweiten Steueranschluss 20 gesehen die fünfte Diode 25 vor der vierten Diode 24 angeordnet. Es ist jedoch gemäß FIG 5 alternativ ebenso möglich, die umgekehrten Reihenfolgen vorzusehen.

Ebenso wie bei der Ausgestaltung der FIG 3 umfasst die erste Diodenschaltung 16 in diesem Fall entsprechend der Darstellung in FIG 5 vorzugsweise zusätzlich die dritte Diode 19. Zur weiteren Ausgestaltung, insbesondere der Auslegung der dritten Diode 19 und gegebenenfalls der Verteilung der erforderlichen Durchbruchspannung auf die erste und die dritte Diode 17, 19 sind die Ausführungen zu FIG 3 weiterhin gültigen.

In analoger Weise umfasst bei der Ausgestaltung der FIG 5 die zweite Diodenschaltung 23 vorzugsweise zusätzlich eine sechste Diode 26. Die sechste Diode 26 ist von dem zweiten Leistungsanschluss 11 zum zweiten Steueranschluss 20 gesehen nach der fünften Diode 25 angeordnet und von dem zweiten Leistungsanschluss 11 zum zweiten Steueranschluss 20 gesehen in Durchlassrichtung gepolt.

Ebenso wie beim Zusammenwirken der ersten und der dritten Diode 17, 19 können auch die Durchbruchspannungen der vierten und der sechsten Diode 24, 26 addiert werden. Analog zur ersten und zur dritten Diode 17, 19 ist es bei der Ausgestaltung gemäß FIG 5 daher möglich, dass die vierte Diode 24 eine Durchbruchspannung unterhalb der Durchbruchspannung des Schaltelements 9 aufweist. Denn es ist ausreichend, dass die Summe der Durchbruchspannungen der vierten und der sechsten Diode 24, 26 zusammen oberhalb der Durchbruchspannung des Schaltelements 9 liegt.

Ebenso wie bei den Ausgestaltungen der FIG 2 und 3 ist auch bei den Ausgestaltungen der FIG 4 und 5 das Schaltelement 9 vorzugsweise als spannungsgesteuertes Schaltelement ausgebildet. Nachfolgend werden in Verbindung mit den FIG 6 bis 8 mögliche Ausgestaltungen des Schaltelements 9 der dritten Schalteinrichtung 7 erläutert. Die Diodenschaltungen 16, 23 sind in den FIG 6 bis 8 nur als Einheiten dargestellt. Der innere Aufbau der Diodenschaltungen 16, 23 ist so, wie dies vorstehend in Verbindung mit den FIG 4 und 5 erläutert wurde.

In der Ausgestaltung gemäß FIG 6 weist das Schaltelement 9 ein erstes und ein zweites Transistorelement 27, 28 auf. Die beiden Transistorelemente 27, 28 sind in Reihe geschaltet. Bei dieser Ausgestaltung ist der erste Steueranschluss 12 Bestandteil des ersten Transistorelements 27, der zweite Steueranschluss 20 Bestandteil des zweiten Transistorelements 28. Weiterhin ist dem ersten Transistorelement 27 eine erste Freilaufdiode 29 parallel geschaltet. Die erste Freilaufdiode 29 ist von dem ersten zum zweiten Leistungsanschluss 10, 11 gesehen in Sperrrichtung gepolt. Ebenso ist dem zweiten Transistorelement 28 eine zweite Freilaufdiode 30 parallel geschaltet, die von dem ersten zum zweiten Leistungsanschluss 10, 11 gesehen jedoch in Durchlassrichtung gepolt ist.

Bei der Ausgestaltung gemäß FIG 6 ist von dem ersten zum zweiten Leistungsanschluss 10, 11 gesehen das zweite Transistorelement 28 vor dem ersten Transistorelement 27 angeordnet. Diese Anordnung ist bevorzugt. Prinzipiell wäre jedoch auch die umgekehrte Anordnung möglich. Weiterhin sind üblicherweise die Transistorelemente 27, 28 als spannungsgesteuerte Transistoren ausgebildet, beispielsweise als IGBT oder als FET. Im Ergebnis ist damit auch das Schaltelement 9 als Ganzes als spannungsgesteuertes Schaltelement ausgebildet.

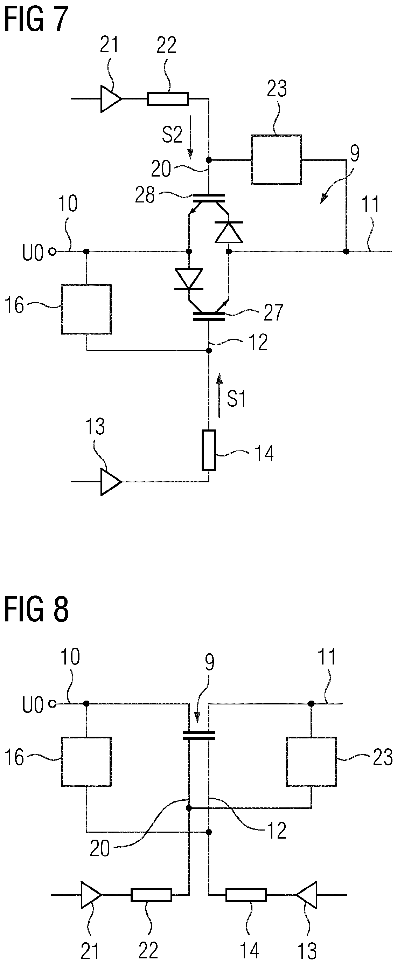

Auch in der Ausgestaltung gemäß FIG 7 weist das Schaltelement 9 ein erstes und ein zweites Transistorelement 27, 28 auf. Die beiden Transistorelemente 27, 28 sind jedoch nicht in Reihe geschaltet, sondern parallelgeschaltet. Auch bei dieser Ausgestaltung ist der erste Steueranschluss 12 Bestandteil des ersten Transistorelements 27, der zweite Steueranschluss 20 Bestandteil des zweiten Transistorelements 28. Freilaufdioden sind nicht vorhanden. Analog zu FIG 6 sind üblicherweise die Transistorelemente 27, 28 als spannungsgesteuerte Transistoren ausgebildet, beispielsweise als IGBT oder als FET.

Im Ergebnis ist damit auch das Schaltelement 9 als Ganzes als spannungsgesteuertes Schaltelement ausgebildet.

Bei der Ausgestaltung gemäß FIG 8 ist das Schaltelement 9 als intrinsisch bidirektional schaltbares Schaltelement 9 ausgebildet ist. Auch hier ist das Schaltelement 9 als spannungsgesteuertes Schaltelement ausgebildet.

Zusammengefasst betrifft die vorliegende Erfindung somit folgenden Sachverhalt:
Eine elektrische Schalteinrichtung 5 bis 7 weist zum Anschalten eines elektrischen Potenzials U0, U1, U2 an eine Last 8 ein Schaltelement 9 mit einem ersten Leistungsanschluss 10, einem zweiten Leistungsanschluss 11 und einem ersten Steueranschluss 12 auf. Das Schaltelement 9 weist eine Durchbruchspannung auf, bis zu der es maximal betrieben werden kann. Der erste Steueranschluss 12 ist mit einer ersten Treiberschaltung 13 verbunden, über welche dem ersten Steueranschluss 12 ein erstes Steuersignal S1 zuführbar ist, so dass das Schaltelement 9 je nach Wert des ersten Steuersignals S1 für einen Stromfluss von dem ersten zum zweiten Leistungsanschluss 10, 11 durchgeschaltet oder gesperrt ist. Der erste Steueranschluss 12 ist über eine erste Diodenschaltung 16 mit dem ersten Leistungsanschluss 10 verbunden. Die erste Diodenschaltung 16 umfasst eine Reihenschaltung einer ersten und einer zweiten Diode 17, 18. Von dem ersten Leistungsanschluss 10 zum ersten Steueranschluss 12 gesehen ist die erste Diode 17 in Durchlassrichtung gepolt, die zweite Diode 18 in Sperrrichtung. Die zweite Diode 18 ist als Zenerdiode ausgebildet ist und weist eine Durchbruchspannung zwischen einer Betriebsspannung U der elektrischen Schalteinrichtung 5 bis 7 und der Durchbruchspannung des Schaltelements 9 auf. Die erste Diode 17 weist eine Durchbruchspannung oberhalb der Durchbruchspannung des Schaltelements 9 auf.

Die vorliegende Erfindung weist viele Vorteile auf. Sie ist einfach und arbeitet zuverlässig und kann bei vielen Schalteinrichtungen 5 bis 7 eingesetzt werden. Vor allem aber kann sie auch dann eingesetzt werden, wenn die Schalteinrichtung 5 bis 7 - so wie vorliegend die dritte Schalteinrichtung 7 - bidirektional betrieben werden soll. Dies gilt vorliegend unabhängig von der konkreten Ausgestaltung des entsprechenden Schaltelements 9.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Elektrische Schalteinrichtung zum Anschalten eines elektrischen Potenzials (U0, U1, U2) an eine Last (8),
- wobei die Schalteinrichtung ein Schaltelement (9) mit einem ersten Leistungsanschluss (10), einem zweiten Leistungsanschluss (11) und einem ersten Steueranschluss (12) aufweist,
- wobei das Schaltelement (9) eine Durchbruchspannung aufweist, bis zu der es maximal betrieben werden kann,
- wobei der erste Steueranschluss (12) mit einer ersten Treiberschaltung (13) verbunden ist, über welche dem ersten Steueranschluss (12) ein erstes Steuersignal (S1) zuführbar ist, so dass das Schaltelement (9) je nach Wert des ersten Steuersignals (S1) für einen Stromfluss von dem ersten zum zweiten Leistungsanschluss (10, 11) durchgeschaltet oder gesperrt ist,
- wobei der erste Steueranschluss (12) über eine erste Diodenschaltung (16) mit dem ersten Leistungsanschluss (10) verbunden ist,
- wobei die erste Diodenschaltung (16) eine Reihenschaltung einer ersten und einer zweiten Diode (17, 18) umfasst,
- wobei von dem ersten Leistungsanschluss (10) zum ersten Steueranschluss (12) gesehen die erste Diode (17) in Durchlassrichtung gepolt ist und die zweite Diode (18) in Sperrrichtung gepolt ist,
- wobei die zweite Diode (18) als Zenerdiode ausgebildet ist und eine Durchbruchspannung zwischen einer Betriebsspannung (U) der elektrischen Schalteinrichtung und der Durchbruchspannung des Schaltelements (9) aufweist,
**dadurch gekennzeichnet,**
**dass** die erste Diode (17) eine Durchbruchspannung oberhalb der Durchbruchspannung des Schaltelements (9) aufweist.

2. Schalteinrichtung nach Anspruch 1,
**dadurch gekennzeichnet,**
**dass** das Schaltelement (9) als spannungsgesteuertes Schaltelement ausgebildet ist.

3. Schalteinrichtung nach Anspruch 1 oder 2,
**dadurch gekennzeichnet,**
**dass** von dem ersten Leistungsanschluss (10) zum ersten Steueranschluss (12) gesehen die zweite Diode (18) vor der ersten Diode (17) angeordnet ist.

4. Schalteinrichtung nach Anspruch 1, 2 oder 3,
**dadurch gekennzeichnet,**
**dass** von dem ersten Leistungsanschluss (10) zum ersten Steueranschluss (12) gesehen die erste Diode (17) vor der zweiten Diode (18) angeordnet ist, dass die erste Diodenschaltung (16) zusätzlich eine dritte Diode (19) umfasst, dass die dritte Diode (19) von dem ersten Leistungsanschluss (10) zum ersten Steueranschluss (12) gesehen nach der zweiten Diode (18) angeordnet ist und dass die dritte Diode (19) von dem ersten Leistungsanschluss (10) zum ersten Steueranschluss (12) gesehen in Durchlassrichtung gepolt ist.

5. Schalteinrichtung nach Anspruch 4,
**dadurch gekennzeichnet,**
**dass** zwar die erste Diode (17) eine Durchbruchspannung unterhalb der Durchbruchspannung des Schaltelements (9) aufweist, die Summe der Durchbruchspannungen der ersten und der dritten Diode (17, 19) zusammen jedoch oberhalb der Durchbruchspannung des Schaltelements liegt.

6. Schalteinrichtung nach einem der Ansprüche 1 bis 5,
**dadurch gekennzeichnet,**
**dass** ein Stromfluss von dem zweiten zum ersten Leistungsanschluss (11, 10) unabhängig davon möglich ist, ob das Schaltelement (9) aufgrund des ersten Steuersignals (S1) für den Stromfluss von dem ersten zum zweiten Leistungsanschluss (10, 11) durchgeschaltet oder gesperrt ist.

7. Schalteinrichtung nach einem der Ansprüche 1 bis 5,
**dadurch gekennzeichnet,**
- **dass** das Schaltelement (9) einen zweiten Steueranschluss (20) aufweist, der mit einer zweiten Treiberschaltung (21) verbunden ist, über welche dem zweiten Steueranschluss (20) ein zweites Steuersignal (S2) zuführbar ist, so dass das Schaltelement (9) je nach Wert des zweiten Steuersignals (S2) für einen Stromfluss von dem zweiten zum ersten Leistungsanschluss (11, 10) durchgeschaltet oder gesperrt ist,
- **dass** der zweite Steueranschluss (20) über eine zweite Diodenschaltung (23) mit dem zweiten Leistungsanschluss (11) verbunden ist,
- **dass** die zweite Diodenschaltung (23) eine Reihenschaltung einer vierten und einer fünften Diode (24, 25) umfasst,
- **dass** von dem zweiten Leistungsanschluss (11) zum zweiten Steueranschluss (20) gesehen die vierte Diode (24) in Durchlassrichtung gepolt ist und die fünfte Diode (25) in Sperrrichtung gepolt ist,
- **dass** die vierte Diode (24) eine Durchbruchspannung oberhalb der Durchbruchspannung des Schaltelements (9) aufweist und
- **dass** die fünfte Diode (25) als Zenerdiode ausgebildet ist und eine Durchbruchspannung zwischen der Betriebsspannung (U) und der Durchbruchspannung des Schaltelements (9) aufweist.

8. Schalteinrichtung nach Anspruch 7,
**dadurch gekennzeichnet,**
**dass** von dem zweiten Leistungsanschluss (11) zum zweiten Steueranschluss (20) gesehen die fünfte Diode (25) vor der vierten Diode (24) angeordnet ist.

9. Schalteinrichtung nach Anspruch 7 oder 8,
**dadurch gekennzeichnet,**
**dass** von dem zweiten Leistungsanschluss (11) zum zweiten Steueranschluss (20) gesehen die vierte Diode (24) vor der fünften Diode (25) angeordnet ist, dass die zweite Diodenschaltung (23) zusätzlich eine sechste Diode (26) umfasst, dass die sechste Diode (26) von dem zweiten Leistungsanschluss (11) zum zweiten Steueranschluss (20) gesehen nach der fünften Diode (25) angeordnet ist und dass die sechste Diode (26) von dem zweiten Leistungsanschluss (11) zum zweiten Steueranschluss (20) gesehen in Durchlassrichtung gepolt ist.

10. Schalteinrichtung nach Anspruch 9,
**dadurch gekennzeichnet,**
**dass** zwar die vierte Diode (24) eine Durchbruchspannung unterhalb der Durchbruchspannung des Schaltelements (9) aufweist, die Summe der Durchbruchspannungen der vierten und der sechsten Diode (24, 26) zusammen jedoch oberhalb der Durchbruchspannung des Schaltelements (9) liegt.

11. Schalteinrichtung nach einem der Ansprüche 7 bis 10,
**dadurch gekennzeichnet,**
- **dass** das Schaltelement (9) ein erstes und ein zweites Transistorelement (27, 28) aufweist,
- **dass** das erste und das zweite Transistorelement (27, 28) in Reihe geschaltet sind,
- **dass** der erste Steueranschluss (11) Bestandteil des ersten Transistorelements (27) ist und der zweite Steueranschluss (20) Bestandteil des zweiten Transistorelements (28) ist,
- **dass** dem ersten Transistorelement (27) eine erste Freilaufdiode (29) parallelgeschaltet ist, die von dem ersten zum zweiten Leistungsanschluss (10, 11) gesehen in Sperrrichtung gepolt ist und
- **dass** dem zweiten Transistorelement (28) eine zweite Freilaufdiode (30) parallelgeschaltet ist, die von dem ersten zum zweiten Leistungsanschluss (10, 11) gesehen in Durchlassrichtung gepolt ist.

12. Schalteinrichtung nach Anspruch 11,
**dadurch gekennzeichnet,**
**dass** von dem ersten zum zweiten Leistungsanschluss (10, 11) gesehen das zweite Transistorelement (28) vor dem ersten Transistorelement (27) angeordnet ist.

13. Schalteinrichtung nach einem der Ansprüche 7 bis 10,
**dadurch gekennzeichnet,**
**dass** das Schaltelement (9) ein erstes und ein zweites Transistorelement (27, 28) aufweist, dass das erste und das zweite Transistorelement (27, 28) parallelgeschaltet sind und dass der erste Steueranschluss (11) Bestandteil des ersten Transistorelements (27) ist und der zweite Steueranschluss (20) Bestandteil des zweiten Transistorelements (28) ist.

14. Schalteinrichtung nach einem der Ansprüche 7 bis 10,
**dadurch gekennzeichnet,**
**dass** das Schaltelement (9) als intrinsisch bidirektional schaltbares Schaltelement ausgebildet ist.

15. Schalteinrichtung nach einem der Ansprüche 7 bis 14,
**dadurch gekennzeichnet,**
**dass** der erste Leistungsanschluss (10) mit einem mittleren (U0) von drei Gleichspannungspotentialen (U0, U1, U2) eines Dreilevel-Umrichters (4) verbunden ist und der zweite Leistungsanschluss (11) mit einem Wechselspannungsanschluss des Dreilevel-Umrichters (4) verbunden ist.

## Geänderte Patentansprüche

### Geänderte Patentansprüche gemäss Regel 137(2) EPÜ.

**1.** Elektrische Schalteinrichtung zum Anschalten eines elektrischen Potenzials (U0, U1, U2) an eine Last (8),
- wobei die Schalteinrichtung ein Schaltelement (9) mit einem ersten Leistungsanschluss (10), einem zweiten Leistungsanschluss (11) und einem ersten Steueranschluss (12) aufweist,
- wobei das Schaltelement (9) eine Durchbruchspannung aufweist, bis zu der es maximal betrieben werden kann,
- wobei der erste Steueranschluss (12) mit einer ersten Treiberschaltung (13) verbunden ist, über welche dem ersten Steueranschluss (12) ein erstes Steuersignal (S1) zuführbar ist, so dass das Schaltelement (9) je nach Wert des ersten Steuersignals (S1) für einen Stromfluss von dem ersten zum zweiten Leistungsanschluss (10, 11) durchgeschaltet oder gesperrt ist,
- wobei der erste Steueranschluss (12) über eine erste Diodenschaltung (16) mit dem ersten Leistungsanschluss (10) verbunden ist,
- wobei die erste Diodenschaltung (16) eine Reihenschaltung einer ersten und einer zweiten Diode (17, 18) umfasst,
- wobei von dem ersten Leistungsanschluss (10) zum ersten Steueranschluss (12) gesehen die erste Diode (17) in Durchlassrichtung gepolt ist und die zweite Diode (18) in Sperrrichtung gepolt ist,
- wobei die zweite Diode (18) als Zenerdiode ausgebildet ist und eine Durchbruchspannung zwischen einer Betriebsspannung (U) der elektrischen Schalteinrichtung und der Durchbruchspannung des Schaltelements (9) aufweist,
**dadurch gekennzeichnet,**
**dass** die erste Diode (17) eine Durchbruchspannung oberhalb der Durchbruchspannung des Schaltelements (9) aufweist.

**2.** Schalteinrichtung nach Anspruch 1,
**dadurch gekennzeichnet,**
**dass** das Schaltelement (9) als spannungsgesteuertes Schaltelement ausgebildet ist.

**3.** Schalteinrichtung nach Anspruch 1 oder 2,
**dadurch gekennzeichnet,**
**dass** von dem ersten Leistungsanschluss (10) zum ersten Steueranschluss (12) gesehen die zweite Diode (18) vor der ersten Diode (17) angeordnet ist.

**4.** Schalteinrichtung nach Anspruch 1, 2 oder 3,
**dadurch gekennzeichnet,**
**dass** von dem ersten Leistungsanschluss (10) zum ersten Steueranschluss (12) gesehen die erste Diode (17) vor der zweiten Diode (18) angeordnet ist, dass die erste Diodenschaltung (16) zusätzlich eine dritte Diode (19) umfasst, dass die dritte Diode (19) von dem ersten Leistungsanschluss (10) zum ersten Steueranschluss (12) gesehen nach der zweiten Diode (18) angeordnet ist und dass die dritte Diode (19) von dem ersten Leistungsanschluss (10) zum ersten Steueranschluss (12) gesehen in Durchlassrichtung gepolt ist.

**5.** Schalteinrichtung nach Anspruch 4,
**dadurch gekennzeichnet,**
**dass** zwar die erste Diode (17) eine Durchbruchspannung unterhalb der Durchbruchspannung des Schaltelements (9) aufweist, die Summe der Durchbruchspannungen der ersten und der dritten Diode (17, 19) zusammen jedoch oberhalb der Durchbruchspannung des Schaltelements liegt.

**6.** Schalteinrichtung nach einem der Ansprüche 1 bis 5,
**dadurch gekennzeichnet,**
**dass** ein Stromfluss von dem zweiten zum ersten Leistungsanschluss (11, 10) unabhängig davon möglich ist, ob das Schaltelement (9) aufgrund des ersten Steuersignals (S1) für den Stromfluss von dem ersten zum zweiten Leistungsanschluss (10, 11) durchgeschaltet oder gesperrt ist.

**7.** Schalteinrichtung nach einem der Ansprüche 1 bis 5,
**dadurch gekennzeichnet,**
- **dass** das Schaltelement (9) einen zweiten Steueranschluss (20) aufweist, der mit einer zweiten Treiberschaltung (21) verbunden ist, über welche dem zweiten Steueranschluss (20) ein zweites Steuersignal (S2) zuführbar ist, so dass das Schaltelement (9) je nach Wert des zweiten Steuersignals (S2) für einen Stromfluss von dem zweiten zum ersten Leistungsanschluss (11, 10) durchgeschaltet oder gesperrt ist,
- **dass** der zweite Steueranschluss (20) über eine zweite Diodenschaltung (23) mit dem zweiten Leistungsanschluss (11) verbunden ist,
- **dass** die zweite Diodenschaltung (23) eine Reihenschaltung einer vierten und einer fünften Diode (24, 25) umfasst,
- **dass** von dem zweiten Leistungsanschluss (11) zum zweiten Steueranschluss (20) gesehen die vierte Diode (24) in Durchlassrichtung gepolt ist und die fünfte Diode (25) in Sperrrichtung gepolt ist,
- **dass** die vierte Diode (24) eine Durchbruchspannung oberhalb der Durchbruchspannung des Schaltelements (9) aufweist und
- **dass** die fünfte Diode (25) als Zenerdiode ausgebildet ist und eine Durchbruchspannung zwischen der Betriebsspannung (U) und der Durchbruchspannung des Schaltelements (9) aufweist.

**8.** Schalteinrichtung nach Anspruch 7,
**dadurch gekennzeichnet,**
**dass** von dem zweiten Leistungsanschluss (11) zum zweiten Steueranschluss (20) gesehen die fünfte Diode (25) vor der vierten Diode (24) angeordnet ist.

**9.** Schalteinrichtung nach Anspruch 7 oder 8,
**dadurch gekennzeichnet,**
**dass** von dem zweiten Leistungsanschluss (11) zum zweiten Steueranschluss (20) gesehen die vierte Diode (24) vor der fünften Diode (25) angeordnet ist, dass die zweite Diodenschaltung (23) zusätzlich eine sechste Diode (26) umfasst, dass die sechste Diode (26) von dem zweiten Leistungsanschluss (11) zum zweiten Steueranschluss (20) gesehen nach der fünften Diode (25) angeordnet ist und dass die sechste Diode (26) von dem zweiten Leistungsanschluss (11) zum zweiten Steueranschluss (20) gesehen in Durchlassrichtung gepolt ist.

**10.** Schalteinrichtung nach Anspruch 9,
**dadurch gekennzeichnet,**
**dass** zwar die vierte Diode (24) eine Durchbruchspannung unterhalb der Durchbruchspannung des Schaltelements (9) aufweist, die Summe der Durchbruchspannungen der vierten und der sechsten Diode (24, 26) zusammen jedoch oberhalb der Durchbruchspannung des Schaltelements (9) liegt.

**11.** Schalteinrichtung nach einem der Ansprüche 7 bis 10,
**dadurch gekennzeichnet,**
- **dass** das Schaltelement (9) ein erstes und ein zweites Transistorelement (27, 28) aufweist,
- **dass** das erste und das zweite Transistorelement (27, 28) in Reihe geschaltet sind,
- **dass** der erste Steueranschluss (11) Bestandteil des ersten Transistorelements (27) ist und der zweite Steueranschluss (20) Bestandteil des zweiten Transistorelements (28) ist,
- **dass** dem ersten Transistorelement (27) eine erste Freilaufdiode (29) parallelgeschaltet ist, die von dem ersten zum zweiten Leistungsanschluss (10, 11) gesehen in Sperrrichtung gepolt ist und
- **dass** dem zweiten Transistorelement (28) eine zweite Freilaufdiode (30) parallelgeschaltet ist, die von dem ersten zum zweiten Leistungsanschluss (10, 11) gesehen in Durchlassrichtung gepolt ist.

**12.** Schalteinrichtung nach Anspruch 11,
**dadurch gekennzeichnet,**
**dass** von dem ersten zum zweiten Leistungsanschluss (10, 11) gesehen das zweite Transistorelement (28) vor dem ersten Transistorelement (27) angeordnet ist.

**13.** Schalteinrichtung nach einem der Ansprüche 7 bis 10,
**dadurch gekennzeichnet,**
**dass** das Schaltelement (9) ein erstes und ein zweites Transistorelement (27, 28) aufweist, dass das erste und das zweite Transistorelement (27, 28) parallelgeschaltet sind und dass der erste Steueranschluss (11) Bestandteil des ersten Transistorelements (27) ist und der zweite Steueranschluss (20) Bestandteil des zweiten Transistorelements (28) ist.

**14.** Schalteinrichtung nach einem der Ansprüche 7 bis 10,
**dadurch gekennzeichnet,**
**dass** das Schaltelement (9) als intrinsisch bidirektional schaltbares Schaltelement ausgebildet ist.

**15.** Schalteinrichtung nach einem der Ansprüche 7 bis 14,
**dadurch gekennzeichnet,**
**dass** der erste Leistungsanschluss (10) mit einem mittleren (U0) von drei Gleichspannungspotentialen (U0, U1, U2) eines Dreilevel-Umrichters (4) verbunden ist und der zweite Leistungsanschluss (11) mit einem Wechselspannungsanschluss des Dreilevel-Umrichters (4) verbunden ist.

**1.** Elektrische Schalteinrichtung zum Anschalten eines elektrischen Potenzials (U0, U1, U2) an eine Last (8),
- wobei die Schalteinrichtung ein Schaltelement (9) mit einem ersten Leistungsanschluss (10), einem zweiten Leistungsanschluss (11) und einem ersten Steueranschluss (12) aufweist,
- wobei das Schaltelement (9) eine Durchbruchspannung aufweist, bis zu der es maximal betrieben werden kann,
- wobei der erste Steueranschluss (12) mit einer ersten Treiberschaltung (13) verbunden ist, über welche dem ersten Steueranschluss (12) ein erstes Steuersignal (S1) zuführbar ist, so dass das Schaltelement (9) je nach Wert des ersten Steuersignals (S1) für einen Stromfluss von dem ersten zum zweiten Leistungsanschluss (10, 11) durchgeschaltet oder gesperrt ist,
- wobei der erste Steueranschluss (12) über eine erste Diodenschaltung (16) mit dem ersten Leistungsanschluss (10) verbunden ist,
- wobei die erste Diodenschaltung (16) eine Reihenschaltung einer ersten und einer zweiten Diode (17, 18) umfasst,
- wobei von dem ersten Leistungsanschluss (10) zum ersten Steueranschluss (12) gesehen die erste Diode (17) in Durchlassrichtung gepolt ist und die zweite Diode (18) in Sperrrichtung gepolt ist,
- wobei die zweite Diode (18) als Zenerdiode ausgebildet ist und eine Durchbruchspannung zwischen einer Betriebsspannung (U) der elektrischen Schalteinrichtung und der Durchbruchspannung des Schaltelements (9) aufweist,
**dadurch gekennzeichnet,**
- **dass** die erste Diode (17) eine Durchbruchspannung oberhalb der Durchbruchspannung des Schaltelements (9) aufweist,
- **dass** das Schaltelement (9) einen zweiten Steueranschluss (20) aufweist, der mit einer zweiten Treiberschaltung (21) verbunden ist, über welche dem zweiten Steueranschluss (20) ein zweites Steuersignal (S2) zuführbar ist, so dass das Schaltelement (9) je nach Wert des zweiten Steuersignals (S2) für einen Stromfluss von dem zweiten zum ersten Leistungsanschluss (11, 10) durchgeschaltet oder gesperrt ist,
- **dass** der zweite Steueranschluss (20) über eine zweite Diodenschaltung (23) mit dem zweiten Leistungsanschluss (11) verbunden ist,
- **dass** die zweite Diodenschaltung (23) eine Reihenschaltung einer vierten und einer fünften Diode (24, 25) umfasst,
- **dass** von dem zweiten Leistungsanschluss (11) zum zweiten Steueranschluss (20) gesehen die vierte Diode (24) in Durchlassrichtung gepolt ist und die fünfte Diode (25) in Sperrrichtung gepolt ist,
- **dass** die vierte Diode (24) eine Durchbruchspannung oberhalb der Durchbruchspannung des Schaltelements (9) aufweist,
- **dass** die fünfte Diode (25) als Zenerdiode ausgebildet ist und eine Durchbruchspannung zwischen der Betriebsspannung (U) und der Durchbruchspannung des Schaltelements (9) aufweist,
- **dass** das Schaltelement (9) ein erstes und ein zweites Transistorelement (27, 28) aufweist,
- **dass** das erste und das zweite Transistorelement (27, 28) in Reihe geschaltet sind,
- **dass** der erste Steueranschluss (11) Bestandteil des ersten Transistorelements (27) ist und der zweite Steueranschluss (20) Bestandteil des zweiten Transistorelements (28) ist,
- **dass** dem ersten Transistorelement (27) eine erste Freilaufdiode (29) parallelgeschaltet ist, die von dem ersten zum zweiten Leistungsanschluss (10, 11) gesehen in Sperrrichtung gepolt ist,
- **dass** dem zweiten Transistorelement (28) eine zweite Freilaufdiode (30) parallelgeschaltet ist, die von dem ersten zum zweiten Leistungsanschluss (10, 11) gesehen in Durchlassrichtung gepolt ist, und
- **dass** von dem ersten zum zweiten Leistungsanschluss (10, 11) gesehen das zweite Transistorelement (28) vor dem ersten Transistorelement (27) angeordnet ist, so dass die erste Diodenschaltung (16) das zweite Transistorelement (28) übergreift und die zweite Diodenschaltung (16) das erste Transistorelement (27) übergreift.

**2.** Schalteinrichtung nach Anspruch 1,
**dadurch gekennzeichnet,**
**dass** das Schaltelement (9) als spannungsgesteuertes Schaltelement ausgebildet ist.

**3.** Schalteinrichtung nach Anspruch 1 oder 2,
**dadurch gekennzeichnet,**
**dass** von dem ersten Leistungsanschluss (10) zum ersten Steueranschluss (12) gesehen die zweite Diode (18) vor der ersten Diode (17) angeordnet ist und von dem zweiten Leistungsanschluss (11) zum zweiten Steueranschluss (20) gesehen die fünfte Diode (25) vor der vierten Diode (24) angeordnet ist.

**4.** Schalteinrichtung nach Anspruch 1, 2 oder 3,
**dadurch gekennzeichnet,**
- **dass** von dem ersten Leistungsanschluss (10) zum ersten Steueranschluss (12) gesehen die erste Diode (17) vor der zweiten Diode (18) angeordnet ist,
- **dass** die erste Diodenschaltung (16) zusätzlich eine dritte Diode (19) umfasst,
- **dass** die dritte Diode (19) von dem ersten Leistungsanschluss (10) zum ersten Steueranschluss (12) gesehen nach der zweiten Diode (18) angeordnet ist,
- **dass** die dritte Diode (19) von dem ersten Leistungsanschluss (10) zum ersten Steueranschluss (12) gesehen in Durchlassrichtung gepolt ist,
- **dass** von dem zweiten Leistungsanschluss (11) zum zweiten Steueranschluss (20) gesehen die vierte Diode (24) vor der fünften Diode (25) angeordnet ist,
- **dass** die zweite Diodenschaltung (23) zusätzlich eine sechste Diode (26) umfasst,
- **dass** die sechste Diode (26) von dem zweiten Leistungsanschluss (11) zum zweiten Steueranschluss (20) gesehen nach der fünften Diode (25) angeordnet ist und
- **dass** die sechste Diode (26) von dem zweiten Leistungsanschluss (11) zum zweiten Steueranschluss (20) gesehen in Durchlassrichtung gepolt ist.

**5.** Schalteinrichtung nach Anspruch 4,
**dadurch gekennzeichnet,**
**dass** zwar die erste Diode (17) eine Durchbruchspannung unterhalb der Durchbruchspannung des Schaltelements (9) aufweist, die Summe der Durchbruchspannungen der ersten und der dritten Diode (17, 19) zusammen jedoch oberhalb der Durchbruchspannung des Schaltelements liegt und dass zwar die vierte Diode (24) eine Durchbruchspannung unterhalb der Durchbruchspannung des Schaltelements (9) aufweist, die Summe der Durchbruchspannungen der vierten und der sechsten Diode (24, 26) zusammen jedoch oberhalb der Durchbruchspannung des Schaltelements (9) liegt.

**6.** Schalteinrichtung nach einem obigen Ansprüche,
**dadurch gekennzeichnet,**
**dass** der erste Leistungsanschluss (10) mit einem mittleren (U0) von drei Gleichspannungspotentialen (U0, U1, U2) eines Dreilevel-Umrichters (4) verbunden ist und der zweite Leistungsanschluss (11) mit einem Wechselspannungsanschluss des Dreilevel-Umrichters (4) verbunden ist.
